(19) Europäisches Patentamt

European Patent Office

Office européen des brevets

(11) **EP 0 857 795 B1**

(12) **EUROPÄISCHE PATENTSCHRIFT**

(45) Veröffentlichungstag und Bekanntmachung des Hinweises auf die Patenterteilung:
**03.07.2002 Patentblatt 2002/27**

(51) Int Cl.⁷: **C23C 16/02**, C23C 16/42, C23C 16/44

(21) Anmeldenummer: **98101629.8**

(22) Anmeldetag: **30.01.1998**

(54) **Verfahren zur Schichterzeugung auf einer Oberfläche**

Method for coating a surface

Procédé pour le revêtement d'une surface

(84) Benannte Vertragsstaaten:
**DE FR GB IT**

(30) Priorität: **06.02.1997 DE 19704533**

(43) Veröffentlichungstag der Anmeldung:
**12.08.1998 Patentblatt 1998/33**

(73) Patentinhaber: **Infineon Technologies AG**
**81669 München (DE)**

(72) Erfinder:
 • **Karcher, Wolfram**
  **73529 Schwäbisch-Gmünd (DE)**
 • **Labs, Lutz**
  **01324 Dresden (DE)**

(74) Vertreter: **Zimmermann & Partner**
 **Postfach 33 09 20**
 **80069 München (DE)**

(56) Entgegenhaltungen:
 **EP-A- 0 704 551**     **US-A- 5 240 505**

 • **SAITO K ET AL: "EFFECT OF SILICON SURFACE CLEANING ON THE INITIAL STAGE OF SELECTIVE TITANIUM SILICIDE CHEMICAL VAPOR DEPOSITION" JAPANESE JOURNAL OF APPLIED PHYSICS, Bd. 29, Nr. 1, PART 02, 1.Januar 1990, Seiten L185-187, XP000103183**
 • **SAITO K ET AL: "Selective titanium silicide chemical vapor deposition with surface cleaning by silane and ohmic contact formation to very shallow junctions" JOURNAL OF THE ELECTROCHEMICAL SOCIETY, FEB. 1993, USA, Bd. 140, Nr. 2, ISSN 0013-4651, Seiten 513-518, XP002065319**

**Beschreibung**

Die Erfindung betrifft ein Verfahren zur Schichterzeugung auf einer Oberfläche, insbesondere ein Verfahren zur Schichterzeugung auf einer Oberfläche eines Halbleiterprodukts.

Die Herstellung von Halbleiterprodukten, insbesondere von integrierten Halbleiterprodukten, erfordert eine komplexe Folge von Einzelschritten. Dabei nehmen die Herstellungsschritte, bei denen Materialschichten auf der Oberfläche eines Halbleiterprodukts erzeugt werden, eine wichtige Stellung ein.

Für die Erzeugung von Materialschichten steht eine Reihe von Verfahren zur Verfügung, wobei Verfahren, bei denen die zu erzeugenden Schichten aus der Gasphase abgeschieden werden, am häufigsten verwendet werden. Insbesondere die chemische Gasphasenabscheidung (CVD = Chemical Vapour Deposition) gehört zu den wichtigsten Verfahren zur Schichterzeugung. Dabei besteht das CVD-Grundprinzip darin, ausgewählte Prozeßgase über die aufgeheizte Oberfläche eines Halbleiterprodukts zu leiten, auf der die gewünschte Schicht abgeschieden werden soll. Auf der heißen Oberfläche kommt es zu einer Reaktion der Prozeßgase, so daß als Reaktionsprodukte einerseits die gewünschte Schicht und andererseits Restgase entstehen, die abgeführt werden müssen.

Die chemische Gasphasenabscheidung wird üblicherweise bei geringem Druck in Reaktionskammern durchgeführt. Dazu werden die zu verarbeitenden Halbleiterprodukte in die Reaktionskammer eingeschleust und in der Reaktorkammer auf eine vorbestimmte Temperatur aufgeheizt. Durch einen oder mehrere Gaszuflüsse werden die Prozeßgase auf die Oberfläche des Halbleiterprodukts geleitet und die durch die Reaktion der Prozeßgase entstehenden Restgase werden aus der Reaktionskammer abgepumpt.

Wenn nun ein neues Halbleiterprodukt zur Schichterzeugung in die Reaktionskammer eingeschleust wird, ergibt sich häufig das Problem, daß in der Reaktionskammer noch ein aggressives Gas von dem vorhergehenden Schichterzeugungsprozeß vorhanden ist. Dieses aggressive Gas kann ein Rückstand eines der zur Schichterzeugung verwendeten Prozeßgase oder eines der durch die Reaktion der Prozeßgase entstehenden Restgase sein. Durch das aggressive Gas kann es auf der Oberflächen des Halbleiterprodukts zu unerwünschten Reaktionen kommen, die das Halbleiterprodukt beschädigen.

Beispielsweise wird bei der Erzeugung von Wolframschichten als eines der Prozeßgase $WF_6$ eingesetzt. Trifft jedoch $WF_6$ auf die Oberfläche einer Ti/TiN-Schicht, die als Kontakt- und Barriereschicht zwischen Silizium und Wolfram dient, so kann es zu unerwünschten Reaktionen von $WF_6$ und Titan kommen:

$$WF_6 + Ti \rightarrow W + TiF_x.$$

Derartige Reaktionen von $WF_6$ und Titan lösen die Ti/TiN-Schicht auf oder verschlechtern die elektrischen Eigenschaften (z.B. Kontaktwiderstände) und können somit die Funktionsfähigkeit des Halbleiterprodukts gefährden. Auch wenn $WF_6$ auf eine Siliziumoberfläche trifft, kann es zu einer unerwünschten Reaktion kommen, welche die Siliziumoberfläche beschädigt:

$$2WF_6 + 3Si \rightarrow 2W + 3SiF_4.$$

EP 0 704 551 A1 beschreibt Verfahren zum Schutz vor agressiven Restgasen mit Hilfe von Spülungen einer Reaktionskammer mit Hilfe von Silan. Die Reaktionskammer wird vor dem Entnehmen eines zuletzt bearbeiteten Halbleiterprodukts, alternativ oder zusätzlich auch nach Einführen eines nächsten, zu brearbeitenden Halbleiterprodukts mit Silan gespült.

Der Erfindung liegt daher die Aufgabe zugrunde, ein Verfahren zur Schichterzeugung auf einer Oberfläche anzugeben, bei welchem eine Schädigung der Oberfläche durch aggressive Gase vermieden wird.

Diese Aufgabe wird durch das Verfahren gemäß dem unabhängigen Patentanspruch 1 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird ein Verfahren zur Schichterzeugung auf einer Oberfläche bereitgestellt, bei welchem die Oberfläche auf eine vorbestimmte Temperatur erwärmt wird und zumindest ein erstes Gas und zumindest ein zweites Gas, welches mit dem ersten Gas reagiert, zur Schichtabscheidung zu der erwärmten Oberfläche geführt werden, wobei vor und/oder bei dem Erwärmen der Oberfläche zumindest ein Schutzgas zu der Oberfläche geführt wird.

Durch das Schutzgas wird einerseits das noch in der Reaktionskammer verbliebene aggressive Gas verdünnt, andererseits adsorbiert ein Teil des Schutzgases an der kalten Oberfläche, so daß es an der Oberfläche bevorzugt zu Reaktionen von dem aggressiven Gas mit dem Schutzgas kommt und die Oberflächenschichten selbst somit im wesentlichen unbeschädigt bleiben. Dabei ist das Schutzgas so gewählt, daß es im Vergleich zu den Atomen oder Molekülen auf der zu beschichteten Oberfläche eine höhere Reaktivität mit dem aggressiven Gas aufweist.

Die Erfindung kann auch als ein Verfahren zum Schutz einer Oberfläche bei einem Verfahren zur Schichterzeugung angesehen werden. Das Verfahren zum Schutz einer Oberfläche ist dadurch gekennzeichnet, daß vor und/oder bei dem Aufheizen der Oberfläche ein Schutzgas zu der Oberfläche geführt wird.

Bevorzugt wird das Schutzgas zusammen mit einem Trägergas, insbesondere Argon, zu der Oberfläche geführt.

Weiterhin ist bevorzugt, wenn mit dem Verfahren zur Schichterzeugung eine metallische Schicht, insbesondere eine Wolframschicht oder eine Molybdänschicht, abgeschieden wird.

Bevorzugt wird als erstes Gas zumindest ein Gas aus der Gruppe der Metallhalogenide ausgewählt.

Weiterhin ist bevorzugt, wenn als zweites Gas zumindest ein Gas aus der Gruppe der Silane oder Wasserstoff ($H_2$) ausgewählt wird.

Bevorzugt wird als Schutzgas ein Gas aus der Gruppe der Silane, insbesondere Silan ($SiH_4$), verwendet.

Das Verfahren zur Schichterzeugung wird in einer Reaktionskammer durchgeführt. Dabei wird das Schutzgas am Ort der Einschleusung des zu beschichtenden Produkts in die Reaktionskammer zu der Oberfläche geführt. Dadurch kann Konzentration des aggressiven Gases an dieser Stelle verringert werden, ohne daß der Durchsatz für das gesamte Verfahren verringert wird.

Die vorliegende Erfindung wird nun anhand der beiliegenden Zeichnungen näher erläutert. Es zeigen

Fig. 1 eine schematische Darstellung einer CVD-Reaktionskammer, die für das erfindungsgemäße Verfahren verwendet wird,

Fig. 2 eine schematische Seitenansicht der in Fig. 1 gezeigten CVD-Reaktionskammer, und

Fig. 3 eine schematische Darstellung einer weiteren Reaktionskammer zur Durchführung des erfindungsgemäßen Verfahrens.

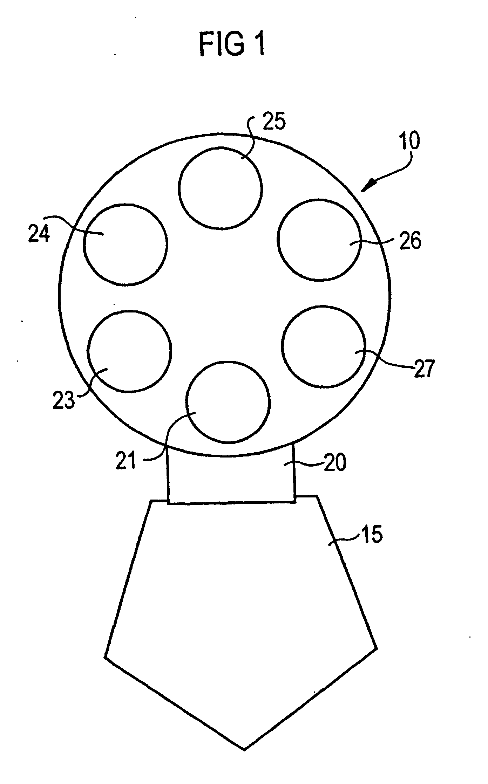

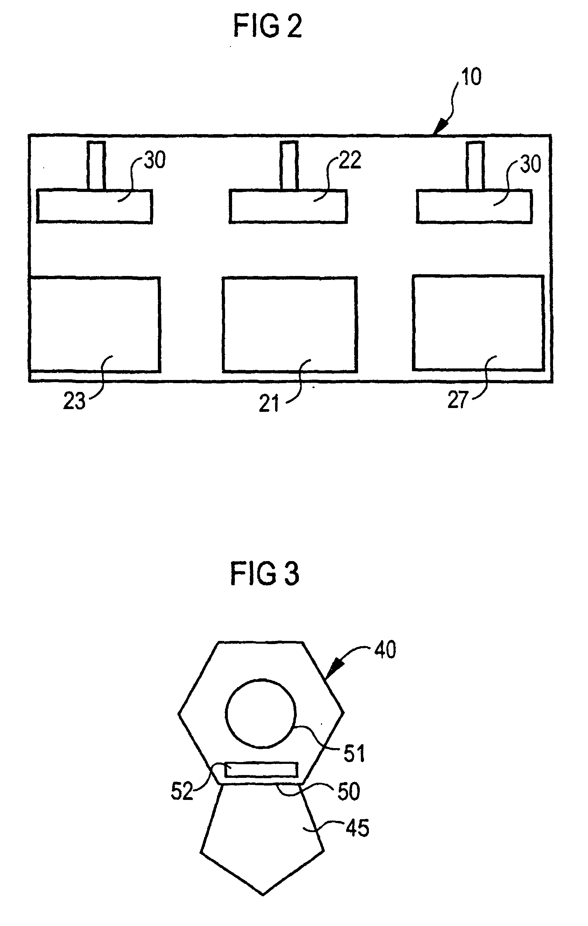

Fig. 1 zeigt eine schematische Darstellung einer CVD-Reaktionskammer, die für das erfindungsgemäße Verfahren verwendet wird. Das zu behandelnde Halbleiterprodukt, üblicherweise ein Wafer, wird von einem Transferbereich 15 vor der Reaktionskammer 10 über eine Schleuse 20 in die Reaktionskammer 10 eingeführt. Dort wird das Halbleiterprodukt auf einer Station 21 abgelegt. Über dieser Station 21 befindet sich ein Gaseinlaß 22 (siehe Fig. 2), durch den das Schutzgas und ein Trägergas zu der noch kalten Oberfläche (etwa Raumtemperatur) des Halbleiterprodukts geführt werden. Von der ersten Station 21 hinter der Schleuse 20 wird das Halbleiterprodukt durch einen nicht gezeigten Transportmechanismus zu der Station 23 bewegt. Im weiteren Verlauf der Schichterzeugung wird das Halbleiterprodukt von dieser Station 23 im Uhrzeigersinn zu den weiteren Stationen 24 bis 27 in der Reaktionskammer transportiert. Dabei wird das Halbleiterprodukt auf eine vorgegebene Temperatur aufgeheizt. Über den einzelnen Stationen 23 bis 27 befinden sich ebenfalls Gaseinlässe, durch die die Prozeßgase zur Schichterzeugung auf die Oberfläche des Halbleiterprodukts geführt werden. Befindet sich das Halbleiterprodukt auf der Station 27 und ist der Prozeß der Schichtabscheidung beendet, wird das Halbleiterprodukt von der Station 27 zu der Station 21 transportiert und durch die Schleuse 20 aus der Reaktionskammer entfernt. Gleichzeitig werden weitere Halbleiterprodukte, die sich auf den Stationen 23 bis 26 befinden, jeweils im Uhrzeigersinn eine Station weiter bewegt. Danach wird wieder ein neues Halbleiterprodukt durch die Schleuse 20, über die Station 21 zu der Station 23 in die Reaktionskammer 10 geführt.

Beispielsweise kann mittels einer derartigen Reaktionskammer 10 eine Wolframschicht auf einer Ti/TiN-Schicht abgeschieden werden. Ein sich auf der Station 23 befindendes Halbleiterprodukt wird dabei auf eine Temperatur von etwa 440°C erhitzt. Durch Gaseinlasse 30 (siehe Fig. 2), die über der Station 23 angeordnet sind, werden die Prozeßgase $WF_6$ und $SiH_4$, die für die Abscheidung einer Wolframkeimschicht notwendig sind, zu der Oberfläche des Halbleiterprodukts geführt. Die Prozeßgase reagieren dabei nach der Reaktionsgleichung:

$$2WF_6 + 3SiH_4 \rightarrow 2W + 3SiF_4 + 6H_2.$$

Ist eine ausreichende Keimschicht auf der Oberfläche des Halbleiterprodukts ausgebildet, wird das Halbleiterprodukt zu der nächsten Station 24 transportiert. Über der Station 24 sind ebenfalls Gaseinlässe angeordnet, durch die die Prozeßgase $WF_6$ und $H_2$, die für die Abscheidung einer Wolframbulkschicht notwendig sind, zu der Oberfläche des Halbleiterprodukts geführt werden. Die Prozeßgase reagieren dabei nach der Reaktionsgleichung:

$$WF_6 + 3H_2 \rightarrow W + 6HF .$$

Diese Abscheidung einer Wolframbulkschicht wiederholt sich auf den Stationen 25 bis 27, so daß eine ausreichend dicke Wolframschicht erzeugt werden kann.

Durch die gewählte Anordnung der Stationen in der Reaktionskammer ist es natürlich möglich, daß die aggressiven Gase $WF_6$ und HF zu dem kalten Halbleiterprodukt auf der Station 21 gelangen, das gerade neu in die Reaktionskammer eingeschleust worden ist. Diese aggressiven Gase könnten dabei mit den Oberflächenschichten des kalten Halbleiterprodukts reagieren und somit die Oberfläche beschädigen. Um dies weitgehend zu verhindern, ist über der Station 21 der Gaseinlaß 22 angeordnet, durch den eine Mischung aus Argon (Ar) und Silan ($SiH_4$) auf die Oberfläche des kalten Halbleiterprodukts geführt wird. Durch diese Gase wird einerseits die in der Reaktionskammer anwesenden aggressiven Gase $WF_6$ und HF an der Position der Station 21 verdünnt, andererseits adsorbiert ein Teil des Silans an der kalten Oberfläche, so daß es an der Oberfläche bevorzugt zu Reaktionen von den aggressiven Gasen mit dem Silan (SiH$_4$) kommt und die Oberflächenschichten selbst im wesentlichen unbeschädigt bleiben. Die bei der Reaktion von WF$_6$ und Silan (SiH$_4$) entstehende, einige Nanometer dünne Wolframbzw Wolframsilizidschicht braucht nicht entfernt zu werden. Durch diese dünne Zwischenschicht wird das weitere Aufbringen der Wolframschicht nicht behindert.

Durch das Einbringen des zusätzlichen Silans über der Station 21 werden die anderen chemischen Reaktionen in der Reaktionskammer nicht beeinflußt, so daß sich das Schutzgas nicht negativ auf den Durchsatz der Halbleiterprodukte durch die Reaktionskammer 10 bemerkbar macht.

Fig. 3 zeigt eine schematische Darstellung einer weiteren Reaktionskammer zur Durchführung des erfindungsgemäßen Verfahrens. Wiederum wird das zu behandelnde Halbleiterprodukt, üblicherweise ein Wafer, von einem Transferbereich 45 vor der Reaktionskammer 40 über eine Schleuse 50 in die Reaktionskammer 40 eingeführt. Auf dem Weg von der Schleuse 50 zu einer Station 51 wird das Halbleiterprodukt unter einem Gaseinlaß 52 durchgeführt, durch den ein Schutzgas auf die Oberfläche des Halbleiterprodukts geleitet wird. Auf der Station 51 wird das Halbleiterprodukt auf eine vorgegebene Temperatur erhitzt. Über der Station 51 befindet sich ein weiterer Gaseinlaß (nicht gezeigt), durch die Prozeßgase zu der Oberfläche des Halbleiterprodukts geführt werden. Im Gegensatz zu der Reaktionskammer 10 aus Fig. 1 ist die Reaktionskammer 40 so ausgelegt, daß immer nur ein Halbleiterprodukt in der Reaktionskammer 40 bearbeitet werden kann. Wiederum werden durch das Schutzgas einerseits die in der Reaktionskammer anwesenden aggressive Gase, beispielsweise WF$_6$ und HF, an der Position hinter Schleuse 50 verdünnt, andererseits adsorbiert ein Teil des Schutzgases an der kalten Oberfläche, so daß es an der Oberfläche bevorzugt zu Reaktionen von dem aggressiven Gas mit dem Schutzgas kommt und die Oberflächenschichten selbst im wesentlichen unbeschädigt bleiben. Durch den zusätzlich vorgesehen Gaseinlaß für das Schutzgas wird auch bei der Reaktionskammer 40 der Durchsatz der Halbleiterprodukte durch die Reaktionskammer 40 nicht negativ beeinflußt.

**Patentansprüche**

1. Verfahren zur Schichterzeugung auf einer Oberfläche eines Halbleiterprodukts, bei dem

   - das Halbleiterprodukt in eine Reaktionskammer (40) eingeführt wird,
   - seine Oberfläche auf eine vorbestimmte Temperatur erwärmt wird und
   - zumindest ein erstes Gas und zumindest ein zweites Gas, welches mit dem ersten Gas reagiert, zur Schichtabscheidung der erwärmten Oberfläche zugeführt werden,

   wobei der Oberfläche vor dem Erwärmen ein Schutzgas zugeführt wird, welches auf der Oberfläche in kaltem Zustand adsorbiert,
   **dadurch gekennzeichnet,**
   **daß** das Halbleiterprodukt über eine Schleuse (50) in die Reaktionskammer eingeführt wird und daß das auf der Oberfläche in kaltem Zustand adsorbierende Schutzgas dem Halbleiterprodukt auf seinem Weg von der Schleuse in die Reaktionskammer zugeführt wird.

2. Verfahren nach Anspruch 1,
   **dadurch gekennzeichnet,**
   **daß** das Schutzgas und ein Trägergas, insbesondere Argon, zu der Oberfläche geführt werden.

3. Verfahren nach Anspruch 1 oder 2,
   **dadurch gekennzeichnet,**
   **daß** als erstes Gas zumindest ein Gas aus der Gruppe der Metallhalogenide ausgewählt wird.

4. Verfahren nach einem der vorhergehenden Ansprüche,
   **dadurch gekennzeichnet,**
   **daß** als zweites Gas zumindest ein Gas aus der Gruppe der Silane oder Wasserstoff (H$_2$) ausgewählt wird.

5. Verfahren nach einem der vorhergehenden Ansprüche,
   **dadurch gekennzeichnet,**
   **daß** als Schutzgas ein Gas aus der Gruppe der Silane, insbesondere Silan (SiH$_4$), ausgewählt wird.

**Claims**

1. Method for producing layers on a surface of a semiconductor product, in which

   - the semiconductor product is introduced into a reaction chamber (40),
   - its surface is heated to a predetermined temperature, and
   - at least one first gas and at least one second gas, which reacts with the first gas, are supplied to the heated surface in order for layers to be deposited,

   a shielding gas being supplied to the surface prior to heating, which shielding gas is adsorbed on the surface in the cold state,
   **characterized in that** the semiconductor product is introduced into the reaction chamber via a lock (50), and **in that** the shielding gas which is adsorbed on the surface in the cold state is supplied to the semiconductor product as it passes from the lock into the reaction chamber.

2. Method according to Claim 1, **characterized in that** the shielding gas and a carrier gas, in particular argon, are passed to the surface.

3. Method according to Claim 1 or 2, **characterized in that** at least one gas selected from the group consisting of the metal halides is selected as the first gas.

4. Method according to one of the preceding claims, **characterized in that** at least one gas selected from the group consisting of the silanes or hydrogen (H$_2$) is selected as the second gas.

5. Method according to one of the preceding claims, **characterized in that** a gas selected from the group consisting of the silanes, in particular silane (SiH$_4$), is selected as the shielding gas.

**Revendications**

1. Procédé pour revêtir une surface d'un produit semi-conducteur, dans lequel

- on introduit le produit semi-conducteur dans une chambre (40) de réaction,
- on porte la surface à une température déterminée à l'avance et
- on envoie sur la surface chauffée, pour le dépôt d'une couche, au moins un premier gaz et au moins un deuxième gaz qui réagit sur le premier gaz,

dans lequel on envoie sur la surface avant le chauffage un gaz de protection qui est adsorbé à l'état froid sur la surface, **caractérisé en ce que** l'on introduit le produit semi-conducteur par un sas (50) dans la chambre de réaction et **en ce que** l'on envoie le gaz de protection s'adsorbant à l'état froid sur la surface au produit semi-conducteur sur son trajet du sas à chambre de réaction.

2. Procédé suivant la revendication 1, **caractérisé en ce que** l'on fait passer sur la surface le gaz de protection et un gaz porteur, notamment de l'argon.

3. Procédé suivant la revendication 1 ou 2, **caractérisé en ce que** l'on choisit comme premier gaz au moins un gaz dans le groupe des halogénures de métaux.

4. Procédé suivant l'une des revendications précédentes, **caractérisé en ce que** l'on choisit comme deuxième gaz au moins un gaz dans le groupe des silanes ou de l'hydrogène (H$_2$).

5. Procédé suivant l'une des revendications précédentes, **caractérisé en ce que** l'on choisit comme gaz de protection un gaz dans le groupe des silanes, notamment du silane (SiH$_4$).

# FIG 1

# FIG 2

# FIG 3